# EUROPEAN PATENT APPLICATION

(11) **EP 4 752 576 A1**
(43) Date of publication of application: **03.06.2026**
(21) Application number: 24215644.6
(22) Date of filing: 27.11.2024
(51) Int. Cl.: G01R 31/367, G01R 31/392

(54) **METHODS, DEVICES, AND SYSTEMS FOR MULTI-MODAL MACHINE LEARNING ENERGY STORAGE ELEMENT MONITORING**

(71) Applicant: Nio Technology (Anhui) Co., Ltd, Hefei City, Anhui 230601 (CN)
(72) Inventor: TAO, Narisu, 81679 München (DE); KINDERMANN, Frank, 81679 München (DE)
(74) Representative: Vossius & Partner Patentanwälte Rechtsanwälte mbB

(57) **Abstract**

In an aspect, the disclosure is a method for monitoring energy storage element health. The method comprises training a first machine learning, ML, model on a first data set of unlabeled energy storage data comprising data collected from healthy and unhealthy energy storage elements, obtaining first energy storage data from a first energy storage element, generating a first representation vector from the first energy storage data using the first trained model; and monitoring an energy storage element health based on the first representation vector using a second ML model.

## Description

### Field of the disclosure

The present disclosure relates to methods for monitoring energy storage elements using machine learning models and methods for training thereof. The disclosure also relates to corresponding computing devices and systems for implementing these methods.

In particular, the disclosure relates to a methods, devices and systems for detecting anomalies in energy storage element.

### Technical background

The increased electrification of family households, transportation, and other areas of daily life has led to increased demands on suitable energy storage solutions. To provide reliable and safe operation of energy storage elements, data analysis of information obtained from energy storage elements plays a crucial role in identifying anomalies and predicting failures. However, existing methods and devices currently in use to monitor energy storage elements suffer from various drawbacks.

Rule-based systems for analysing energy storage element data and for detecting energy storage element anomalies are easy to understand by a user and allow root cause analysis. However, they are subject to human error, are difficult to scale, and are incapable of detecting unforeseen anomalies.

Machine learning models have also garnered attention for monitoring energy storage elements. The effectiveness of such models hinges on the size and quality of labeled data sets available to train such models. However, as certain anomalies are infrequent and/or rarely occur, available labeled data for training ML models for detecting such anomalies is limited.

This diminishes the suitability of such models for detecting unforeseen or unprecedented anomalies in particular.

### Summary of the disclosure

Some or all of the above problems are addressed by the present disclosure. The disclosure is defined by the independent claims. Preferable embodiments are defined by the sub-features of the dependent claims.

In an aspect, the disclosure is a method for monitoring energy storage element health. The method comprises training a first machine learning, ML, model on a first data set of unlabeled energy storage data comprising data collected from healthy and unhealthy energy storage elements, obtaining first energy storage data from a first energy storage element, generating a first representation vector from the first energy storage data using the first trained model; and monitoring an energy storage element health based on the first representation vector using a second ML model.

Since the first ML model is trained using unlabeled energy storage data, the first ML model can be trained to learn semantic representations from obtained first energy storage data for detecting anomalies. The learned semantic representations can be input into a second ML model for downstream tasks such as classifying the learned semantic representations to predict anomalies. This allows the method according to the disclosure to detect and predict infrequently or rarely occurring anomalies in particular

In preferred embodiments, the first unlabeled data set comprises energy storage data collected from healthy and unhealthy energy storage elements during normal operation of energy storage.

Not discriminating between healthy and unhealthy energy storage elements enlarges the data set used for training the first ML model and improves the ability of the first ML model to generate and predict semantic representations from the obtained first energy storage data.

In the context of the disclosure, a healthy energy storage element may be an energy storage element that operates as intended, i.e., that is capable of operating within one or more predefined parameter(s) or parameter range(s) under normal or intended operating conditions predefined by a manufacturer or designer of the energy storage element. A healthy energy storage element may comprise an energy storage element that was initially flagged or otherwise indicated as potentially faulty and that was determined to be without fault after a subsequent (manual) inspection. Additionally, or alternatively, a healthy energy storage element may be an energy storage element that is free from physical damage such as, e.g., physical deformation or penetration of the energy storage element. An unhealthy energy storage element may be an energy storage element that does not operate as intended, i.e., that does not operate within one or more predefined parameter(s) or parameter range(s) under normal or intended operating conditions initially set out by a manufacturer or designer of the energy storage element. Additionally, or alternatively, an unhealthy energy storage element may comprise an energy storage element that was initially flagged or otherwise indicated as potentially faulty and that was determined to be with fault after a subsequent (manual) inspection.

In preferred embodiments, the first unlabeled data set further comprises one or more of the following energy storage modalities: cell voltage, cell temperature, total current/C rate, state of charge, SoC, coolant temperature inlet/coolant temperature outlet, and/or depth of discharge, DoD, and the first representation vector is generated based on the one or more energy storage modalities comprised by the first unlabeled data set.

The above-specified energy storage modalities have shown to be particularly suitable for detecting anomalies in energy storage elements.

In preferred embodiments, training the first ML model comprises performing contrastive self-supervised learning, SSL, on the first ML model.

Using contrastive SSL to train the first ML model further improves the ability of the first ML model to learn semantic representations from the obtained first energy storage data. This provides several advantages compared to other learning models. Unsupervised learning suffers from sub-optimal performance in processing outliers in a data set due to rare or infrequence anomalies, while supervised learning suffers from the limited amount of labeled data. Additionally, SSL can easily be scaled to larger data sets.

In preferred embodiments, the first ML model further comprises a joint embedding architecture.

A joint embedding architecture maps different types of data modalities into a shared and unified space, which allows to capture similarities and differences between different data modalities. This improves the ability of the first ML to learn representations of the obtained first energy storage data when the first energy storage data comprise a plurality of data modalities.

In preferred embodiments, the joint embedding architecture further comprises one or more convolutional neural networks, CNNs, and/or one or more transformer neural networks, TNNs, and/or one or more deep neural networks, DNNs.

In preferred embodiments, the joint embedding architecture further comprises one TNN, one DNN or one CNN per energy storage modality comprised by the first data set of unlabeled energy storage data. Since different modalities may have different input dimensions or shapes, providing a single dedicated neural network per modality provides improved performance of the first ML model.

In preferred embodiments, performing contrastive SSL is further based on noise contrastive estimation, InfoNCE, loss function.

InfoNCE has shown to be particularly effective for contrastive learning and is scalable for large unlabeled data sets.

In preferred embodiments, monitoring the energy storage element health comprises predicting, by the second ML model, a health event comprising one or more of thermal runaway, self-discharge, and/or status of health, SoH.

The above-specified health events have shown to be particularly detrimental for reliable and safe operation of energy storage elements and predicting these health events allows for appropriate measures to ensure reliable and safe operation.

In preferred embodiments, the second ML model is trained using a second data set of labeled energy storage data collected from unhealthy energy storage elements and/or healthy energy storage elements.

In preferred embodiments, the first energy storage data from the first energy storage element is collected while the first energy storage element is operated under normal operating conditions.

Within the context of the disclosure, normal operating conditions may correspond to operating conditions as intended or predefined by a manufacturer or designer of the energy storage element. Additionally, or alternatively, normal operating conditions may correspond to operating conditions outside of a supervised environment such as a laboratory or (stress) testing environment where the energy storage element may be subjected to operating conditions not intended or initially set out by the manufacturer or designer. Operation conditions predefined by a manufacturer or designer of the energy storage element may comprise one or more of a temperature range, voltage range, or a charge/discharge rate (Crate). Generally, normal operating conditions also comprises conditions under which the energy storage element is free of physical damage.

In preferred embodiments, the first energy storage data is real-time data.

This allows prompt processing of energy storage data for detecting anomalies without substantial time delay.

In preferred embodiments, the first energy storage element is a battery, preferably an electric vehicle, EV, battery.

EV batteries are subject to high power demand, rapid charging, and varying environmental conditions under normal operating conditions and are hence stressed differently compared to other types of energy storage elements found in, e.g., in consumer electronics or stationary energy storage systems, which can lead to a wide range of infrequent or rare anomalies. The method of the disclosure is therefore advantageously used for monitoring EV batteries in particular.

In preferred embodiments, the first energy storage data from the EV battery is further collected from an EV during daily use.

Within the context of the disclosure, daily use may correspond to cases where the EV battery is used in an EV vehicle that is driving around in real-world traffic conditions, i.e., outside of a testing environment.

Using a first ML model to generate and predict representations from unlabeled data allows the method to use unlabeled data collected during daily use. This significantly enlarges the data set that can be input into the first ML model. Additionally, representations learned by the first ML model are more representative of the actual condition of the EV battery, as energy storage data obtained from the EV battery in a laboratory or testing environment is not representative of real-world conditions that the EV battery is typically subjected to.

In another aspect, the disclosure is a computing device comprising one or more processors configured to perform methods according to any one of the above-described embodiments.

In another aspect, the disclosure is a computer program product comprising instructions that, when executed by a one or more processors, cause the one or more processors to perform the method of any one of the above-described embodiments.

In another aspect, the disclosure is a non-transitory computer-readable storage medium comprising the computer program product comprising instructions that, when executed by a one or more processors, cause the one or more processors to perform the method of any one of the above-described embodiments.

Other aspects, features, and advantages will be apparent from the summary above, as well as from the description that follows, including the figures and the claims.

Embodiments of the present disclosure will now be described by way of example only and with reference to the following accompanying drawings. In the figures, the same reference numerals denote the same or similar elements.

### Brief description of the drawings

Fig. 1 shows a flow chart illustrating a method according to embodiments of the disclosure.
Fig. 2 shows a flow chart illustrating a method according to embodiments of the disclosure.
Fig. 3 shows a flow chart illustrating a method according to embodiments of the disclosure.
Fig. 4 shows a system according to embodiments of the disclosure.

### Detailed description

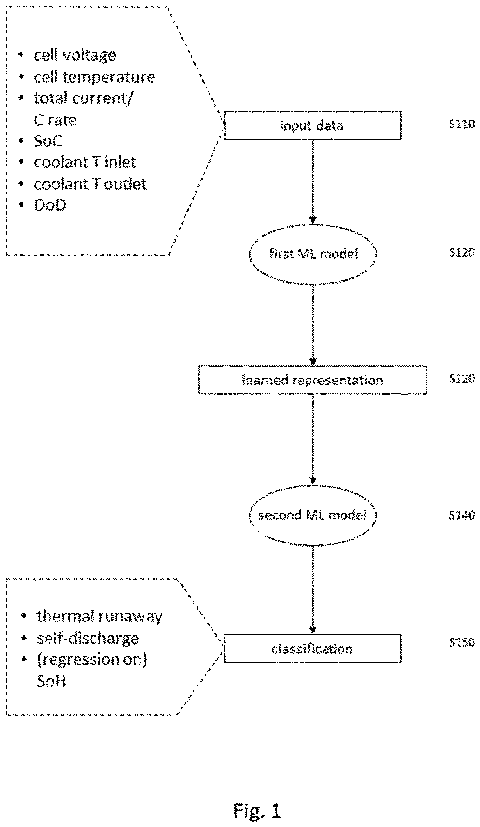

A method for monitoring an energy storage element according to preferred embodiments of the disclosure is illustrated in the flowchart shown in **Fig. 1****.**

In a first step S110, first energy storage data is obtained from one or more energy storage elements. The first energy storage data can comprise different data modalities comprising, but not limited to:
- cell voltage;
- cell temperature;
- total current;
- discharge current/C rate;
- state of charge, SoC;
- coolant temperature;
- coolant temperature inlet/outlet
- depth of discharge;
- cell internal pressure; and/or
- cell acceleration/vibration.

The above data modalities may be obtained for one or more energy storage elements. The above data modalities may be obtained via one or more suitable sensors comprising, but not limited to:
- voltage sensor(s);
- current sensor(s);
- temperature sensor(s);
- SoC sensor(s);
- pressure sensor(s);
- inertial sensor(s).

Notably, the data obtained in step S110 is unlabeled data. In embodiments, the data modalities are obtained from the one or more energy storage elements under normal operating conditions that correspond to operating conditions as intended or initially set by a manufacturer or designer of the energy storage element. Additionally, or alternatively, normal operating conditions may correspond to operating conditions outside of a supervised environment such as a laboratory or (stress) testing environment where the energy storage element may be subjected to operating conditions not intended or initially set out by the manufacturer or designer.

For example, in case the one or more energy storage elements correspond to one or more battery packs or cells of an electric vehicle, EV, battery, data is collected during daily use of the EV, i.e., during normal daily driving of the EV under real-world conditions. Real-world traffic conditions comprise, but are not limited to, frequent and varied de- and acceleration of an EV due to, e.g., traffic lights and signs, right of way at crossings, charging of the EV battery at varying time intervals and/or for varying time durations, and/or varying ambient conditions such as, e.g., different ambient temperatures, due to different weather conditions or time of day.

In step S120, the obtained energy storage data is input into a first machine learning, ML, model. The first ML model is preferably a model trained using contrastive self-supervised learning, SSL.

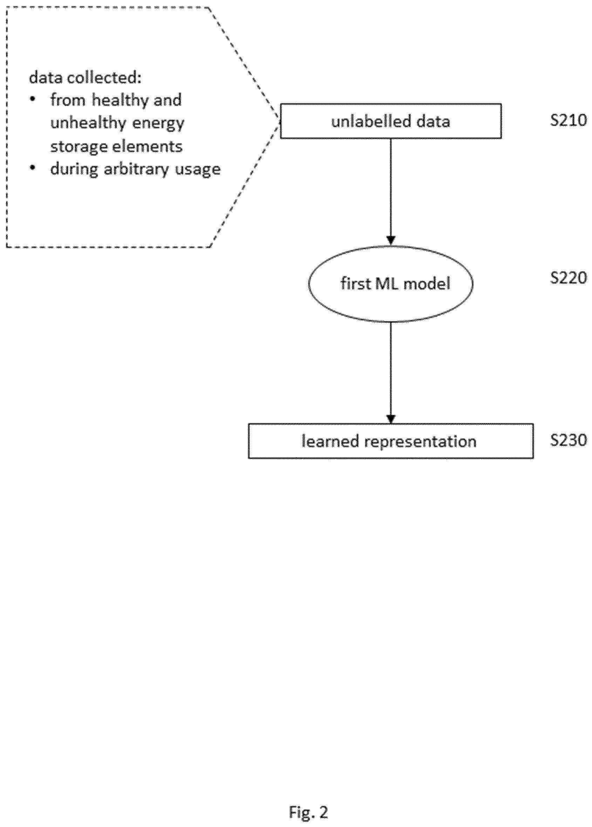

In embodiments, the first ML model comprises a joint embedding architecture. A joint embedding architecture is a machine learning model that projects a plurality of data modalities such as, e.g., text, images, audio, and video into a shared embedding space. Within the shared embedding space, similar data points, e.g., related data modalities, are located closer to each other, while dissimilar data points are located farther apart. Training of the first ML model will be described below in the context of embodiments illustrated in Fig. 2.

In step S130, the first ML model learns one or more representations to generate a representation vector based on the obtained data modalities. A representation vector may be generated for each single energy storage element or for a plurality of energy storage elements.

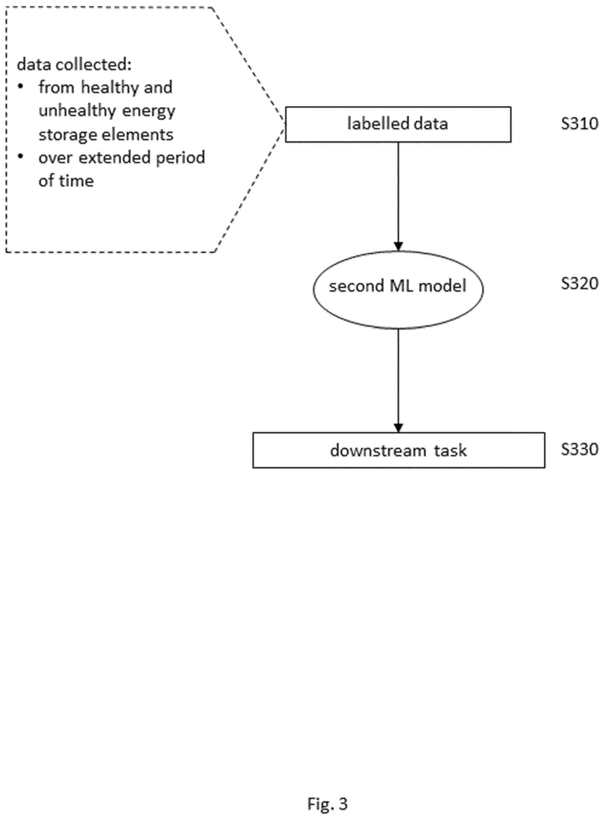

In step S140, the learned representation vector is input into a second ML model for a downstream task such as, e.g., monitoring the health of one or more energy storage elements. However, the downstream task is not limited to the above-specified scenario, and the representation vector generated by the first ML model can be used for any suitable downstream task. The downstream task preferably comprises predicting a health event related to or based on thermal runaway, self-discharge, and/or state of health of one or more energy storage elements. The second ML model may be a ML model chosen based on the type and complexity of the desired downstream task, such as, e.g., a support vector machine, Logistic Regression, or Linear Regression. Training of the second ML will be described below in the context of embodiments illustrated in Fig. 3.

In step S150, the second ML model classifies the representation vector to predict a health event indicative of the health of one or more energy storage elements. This is performed by assessing dissimilarities between representations of different modalities of the representation vector. Health events predicted by the second ML model may preferably comprise one or more of, but are not limited to thermal runaway, self-discharge, and/or (regression on) status of health.

**Fig. 2** shows a flowchart illustrating a method for training a first ML model. The first ML model may be a first ML model as described in the context of embodiments illustrated in Fig. 1.

In step S210, energy storage data for a data set of unlabeled energy storage data is collected. In embodiments, the data set of unlabeled data comprises or substantially consists of data collected from a plurality of energy storage elements comprising data from both healthy and unhealthy energy storage elements. The data may be collected from the energy storage elements under normal operating conditions, i.e., outside of supervised laboratory or testing environments where energy storage elements are typically subjected to charging/discharging cycles which the energy storage elements are typically not subjected to under normal operating conditions. In embodiments, the data set of unlabeled energy storage data comprises or substantially consists of data collected during daily use of one or more energy storage elements. The collected data preferably comprises or substantially consists of real-time data, i.e., data that is preferably provided and made available for further processing when it is generated.

The data set of unlabeled energy storage data may, in case of an EV battery, comprise data collected during daily use of the EV, as described above in the context of embodiments illustrated in Fig. 1. For example, the first ML model can therefore be trained using data indicating a behaviour that a battery exhibits during one or more arbitrary trips.

As with the energy storage data obtained for monitoring the health of an energy storage element, data collected for the first data set of unlabeled data may comprise the following data modalities:
- cell voltage;
- cell temperature;
- total current;
- discharge current/C rate;
- state of charge, SoC;
- coolant temperature;
- coolant temperature inlet/outlet
- depth of discharge;
- cell internal pressure; and/or
- cell acceleration/vibration.

Sensors or other means for collecting the data can be the sensors described for obtaining the energy storage data within the context of embodiments illustrated in Fig. 1 above.

In step S220, the data set of unlabeled energy storage data is used to train the first ML model. In preferred embodiments, the first ML model further comprises or substantially consists of a joint embedding architecture. The joint embedding architecture maps different types of data modalities into a shared and unified embedding space, which allows to capture similarities and differences between different data modalities.

For this, the joint embedding architecture preferably comprises one or more convolutional neural networks, CNNs, deep neural networks, DNNs, and/or transformer neural networks, TNNs, as encoders for mapping the input data modalities into the shared embedding space, wherein the type of encoder may be chosen based on the respective data modality. For example, for an energy storage modality that comprises or substantially consists of highdimensional time series data, a DNN such as a Vision Transformer is preferably used. As a further example, for an energy storage modality that comprises or substantially consists of image data, such as, e.g., optical data obtained for an energy storage element, a CNN is preferably used.

It is further preferred that one CNN, DNN, or TNN is provided per data modality. As the collected data is preferably collected over an extended time period and can corresponds to time series data, one more of the respective CNN, DNN, or TNN are further preferably 1-D neural networks, as these are efficient at handling time series data.

Additionally, or alternatively, it is preferred that the first ML model is trained using self-supervised learning, SSL, particularly using contrastive SSL. In contrastive SSL, the first ML model is optimized to group similar or related data points closer together and pushing dissimilar or unrelated datapoints apart in a shared embedding space. This optimization can be performed using, preferably, a contrastive loss function such as, e.g., InfoNCE. However, other loss functions such as Triplet Loss or N-pair Loss may also be employed. This trains the first ML model to discern positive samples with high similarity and negative samples with low similarity in the absence of labeled energy storage data.

In step S230, the first ML model learns and outputs new representations of the input data provided by the data set of unlabeled energy storage data.

**Fig. 3** shows a flowchart illustrating a method for training a second ML model. The second ML model may be a second ML model as described in the context of embodiments illustrated in Fig. 1.

In step S310, a data set of labelled energy storage data is prepared. The data set of labelled energy storage data comprises or substantially consists of data collected from both healthy and unhealthy energy storage elements. The collected data preferably covers a prolonged period of time spanning, days, weeks or months.

In step S320, the prepared labeled data is used to train the second ML model. The second ML model may preferably be a support vector machine, Logistic Regression, or Linear Regression. Notably, while the second ML model is preferably trained to categorize input data for detecting anomalies in energy storage elements in step S330, the second ML model may also be trained for additional or alternative downstream tasks.

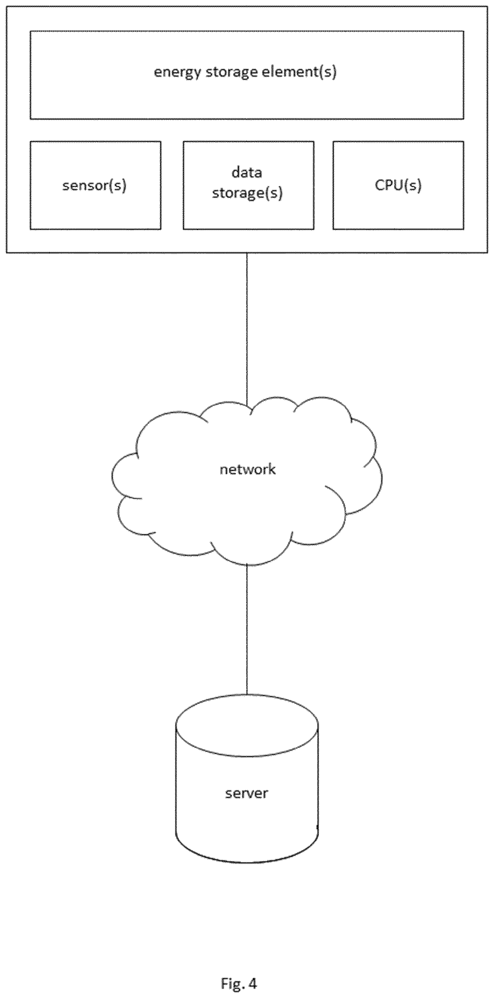

**Fig. 4** illustrates the structure of a system in which methods of any one of the embodiments described above may be implemented.

In embodiments, sensor(s) for obtaining data for the data set of unlabeled energy storage data and/or for the data set of labeled energy storage data may be provided with the one or more energy storage elements from which data is to be obtained. Notably, the sensor(s) and the one or more energy storage elements may be provided as part of a common apparatus.

Obtained energy storage data can be stored in a data storage. The date storage can be provided locally, i.e., with the apparatus. Additionally, or alternatively, data storage may be provided on a remote/external server in communication with the apparatus. Processing of the data and execution of the ML models can be performed locally by one or more processors provided with the apparatus. Additionally, or alternatively, processing of the data and execution of the first ML model and/or the second ML model can be performed remotely/externally on a server.

In embodiments, the apparatus is an EV, and the one or more energy storage elements may correspond to one or more EV battery packs or EV battery cells. Tasks performed by the first ML model and/or the second ML model may be performed by a battery management system, BMS, of the EV. Communication with remote/external servers may be established using wireless communication provided by, e.g., mobile communication networks.

While various embodiments of the present disclosure have been described above, it should be understood that they have been presented by way of example only, and not by way of limitation. Likewise, the various diagrams may depict an example architectural or configuration, which are provided to enable the skilled person art to understand exemplary features and functions of the present disclosure. Such persons would understand, however, that the present disclosure is not restricted to the illustrated example architectures or configurations and can be implemented using a variety of alternative architectures and configurations. Additionally, as would be understood by the skilled person, one or more features of one embodiment can be combined with one or more features of another embodiment described herein. Thus, the breadth and scope of the present disclosure should not be limited by any one of the above-described exemplary embodiments.

The skilled person would further appreciate that any one of the various illustrative logical blocks, units, processors, means, methods and functions described in connection with the aspects disclosed herein can be implemented by electronic hardware, firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, and steps have been described above generally in terms of their functionality. Whether such functionality is implemented as hardware, firmware or software, or a combination of these techniques, depends upon the particular application and design constraints imposed on the overall system. The skilled person can implement the described functionality in various ways for each particular application, but such implementation decisions do not cause a departure from the scope of the present disclosure. In accordance with various embodiments, a processor, apparatus, component, structure, etc. can be configured to perform one or more of the functions described herein.

Furthermore, a skilled person would understand that various illustrative logical blocks, units, devices, components and circuits described herein can be implemented within or performed by an integrated circuit (IC) that can include a general-purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general-purpose processor can be a microprocessor and/or a neural processing unit (NPU), or any conventional processor, controller, or state machine. A processor can also be implemented as a combination of computing devices, e.g., a combination of an NPU and a microprocessor, a plurality of microprocessors, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein but is to be accorded the widest scope consistent with the novel features and principles disclosed herein, as recited in the claims below.

## Claims

1. Method for monitoring energy storage element health, the method comprising:
training a first machine learning, ML, model on a first data set of unlabelled energy storage data comprising data collected from healthy and unhealthy energy storage elements;
obtaining first energy storage data from a first energy storage element;
generating a first representation vector from the first energy storage data using the first trained model; and
monitoring an energy storage element health based on the first representation vector using a second ML model.

2. The method according to the preceding claim, wherein the first unlabelled data set comprises energy storage data collected from healthy and unhealthy energy storage elements during normal operation of energy storage.

3. The method according to the preceding claim, wherein the first unlabelled data set comprises one or more of the following energy storage modalities:
cell voltage,
cell temperature,
total current/C rate,
state of charge, SoC,
coolant temperature inlet/coolant temperature outlet, and
depth of discharge, DoD; and/or
wherein the first representation vector is generated based on the one or more energy storage modalities comprised by the first unlabelled data set.

4. The method according to the any one of the preceding claims, wherein training the first ML model comprises performing contrastive self-supervised learning, SSL, on the first ML model.

5. The method according to the preceding claim, wherein the first ML model comprises a joint embedding architecture.

6. The method according to the preceding claim, wherein the joint embedding architecture comprises one or more convolutional neural networks, CNNs, and/or one or more transformer neural networks, TNNs, and/or one or more deep neural networks, DNNs.

7. The method according to the preceding claim 3 and claim 6, wherein the joint embedding architecture comprises one TNN, one DNN or one CNN per energy storage modality comprised by the first data set of unlabelled energy storage data.

8. The method according to any one of the preceding claims, wherein monitoring the energy storage element health comprises predicting, by the second ML model, a health event comprising one or more of:
thermal runaway;
self-discharge; and/or
status of health, SoH.

9. The method according to any one of the preceding claims, wherein the second ML model is trained using a second data set of labelled energy storage data collected from unhealthy energy storage elements and/or healthy energy storage elements.

10. The method according to any one of the preceding claims, wherein the first energy storage data from the first energy storage element is collected while the first energy storage element is operated under normal operating conditions.

11. The method according to any one of the preceding claims, wherein the first energy storage data is real-time data.

12. The method according to any one of the preceding claims, wherein the first energy storage element is a battery, preferably an electric vehicle, EV, battery, and
wherein, preferably, the first energy storage data from the EV battery is collected from an EV during daily use.

13. Computing device comprising one or more processors configured to perform any one of the preceding methods.

14. Computer program product comprising instructions that, when executed by a one or more processors, cause the one or more processors to perform the method of any one of the preceding claims.

15. Non-transitory computer-readable storage medium comprising the computer program product according to the preceding claim.
